# FASCICULE DE BREVET EUROPEEN

(11) **EP 3 836 214 B1**
(45) Date de publication et mention de la délivrance du brevet: **30.08.2023**
(21) Numéro de dépôt: 20211413.8
(22) Date de dépôt: 03.12.2020
(51) Int. Cl.: H01L 27/144

(54) **CAPTEUR DE LUMIERE**
LICHTSENSOR
LIGHT SENSOR

(30) Priorité: 10.12.2019 FR 1914079
(43) Date de publication de la demande: 16.06.2021
(73) Titulaire: STMICROELECTRONICS SA, 92120 Montrouge (FR); STMicroelectronics Crolles 2 SAS, 38920 Crolles (FR)
(72) Inventeur: LE NEEL, Olivier, 38410 SAINT MARTIN D'URIAGE (FR); MONFRAY, Stéphane, 38320 EYBENS (FR)
(74) Mandataire: Cabinet Beaumont

(56) Documents cités:
- WO-A1-2019/142687
- US-A1- 2016 064 436

## Description

### Capteur de lumière

### Domaine technique

La présente description concerne de façon générale les circuits électroniques. La présente demande concerne plus particulièrement les capteurs de lumière et les procédés de fabrication de filtres de tels capteurs, notamment lorsque ces capteurs de lumière sont prévus pour mettre en oeuvre une analyse spectrale de la lumière qu'ils reçoivent.

### Technique antérieure

On connaît des capteurs de lumière permettant une analyse spectrale de la lumière reçue. Ces capteurs permettent, par exemple, de déterminer pour une quantité donnée de lumière à analyser reçue, comment se répartit cette quantité de lumière entre plusieurs plages de longueurs d'onde. De tels capteurs comprennent généralement plusieurs pixels munis chacun d'un photorécepteur, ou zone de photoconversion, le photorécepteur du pixel étant associé à un filtre bloquant la lumière à des longueurs d'onde données, différentes pour au moins certains de ces pixels. Les documents WO2019/142687 A1 et US2016/064436 A1 divulguent des capteurs de lumière comprenant des filtres métalliques à résonance plasmonique.

### Résumé de l'invention

Il existe un besoin d'un capteur lumière qui pallie tout ou partie des inconvénients des capteurs de lumière connus décrits ci-dessus.

Un mode de réalisation pallie tout ou partie des inconvénients des capteurs de lumière connus décrits ci-dessus.

Un mode de réalisation prévoit un capteur de lumière, comme défini dans la revendication 1, comprenant des pixels comportant chacun une zone de photoconversion, dans lequel un premier desdits pixels comprend un premier filtre à résonance de Fano et un deuxième desdits pixels est dépourvu de filtre à résonance de Fano.

Ledit premier filtre comprend une structure périodique définie dans une première couche d'un premier matériau diélectrique.

Ledit premier filtre comprend une première couche d'un deuxième matériau diélectrique et une deuxième couche du deuxième matériau diélectrique, la première couche du premier matériau reposant sur la première couche du deuxième matériau et étant recouverte par la deuxième couche du deuxième matériau.

Selon un mode de réalisation, le premier matériau est choisi dans le groupe comprenant le carbone amorphe, le silicium amorphe, le nitrure de silicium, le silicium polycristallin non dopé et le carbure de silicium, le deuxième matériau étant de préférence de l'oxyde de silicium.

Selon un mode de réalisation :
la première couche du premier matériau est en contact de la première couche du deuxième matériau ; ou
le premier filtre comporte en outre une deuxième couche du premier matériau reposant sur et en contact avec la première couche du deuxième matériau, et une troisième couche d'un matériau diélectrique, de préférence du deuxième matériau diélectrique, reposant sur et en contact avec la deuxième couche du premier matériau, la première couche du premier matériau reposant sur et contact avec ladite troisième couche.

Selon un mode de réalisation, la structure périodique a un pas inférieur à une longueur d'onde filtrée par ledit premier filtre.

Selon un mode de réalisation, le premier filtre est de type coupe bande.

Selon un mode de réalisation, un troisième desdits pixels comprend un deuxième filtre à résonance de Fano ayant une fréquence centrale différente de celle du premier filtre.

Selon un mode de réalisation, le deuxième filtre comprend toutes les couches du premier filtre et une structure périodique définie dans la première couche du premier matériau.

Selon un mode de réalisation, le capteur comprend en outre un circuit configuré pour :
recevoir, de chacun desdits pixels, un signal de sortie représentatif de la quantité de lumière reçue par la zone de photoconversion du pixel pendant une phase d'illumination du capteur, et pour déterminer, à partir du signal de sortie du premier pixel et du signal de sortie du deuxième pixel, une information représentative de la quantité de lumière reçue par le capteur pendant la phase d'illumination dans une bande de réjection du premier filtre.

Selon un mode de réalisation, le premier pixel comporte en outre un dispositif configuré pour que de la lumière atteigne le premier filtre sous incidence normale.

Selon un mode de réalisation, la première couche du deuxième matériau repose sur un premier revêtement antireflet et/ou un deuxième revêtement antireflet repose sur la deuxième couche du deuxième matériau.

Un mode de mise en oeuvre prévoit un procédé de fabrication, comme défini dans la revendication 11, comprenant les étapes suivantes :
a) former une première couche d'un premier matériau diélectrique reposant sur une première couche d'un deuxième matériau diélectrique ;
b) former au moins un filtre à résonance de Fano en gravant, sur au moins une partie de l'épaisseur de la première couche du premier matériau, des portions de la première couche du premier matériau pour y définir une structure périodique dudit au moins un filtre ;
c) former une deuxième couche du deuxième matériau de manière à recouvrir la première couche du premier matériau ; et
d) aplanir une face exposée de la deuxième couche du deuxième matériau par un polissage mécano-chimique.

Selon un mode de réalisation, le procédé comprend en outre :
avant l'étape a), une étape de formation d'un premier revêtement antireflet sur lequel repose la première couche du deuxième matériau ; et/ou
à l'étape d), une étape de formation d'un deuxième revêtement antireflet reposant sur la deuxième couche du deuxième matériau.

Selon un mode de réalisation :
l'étape a) comprend la formation d'une deuxième couche du premier matériau diélectrique reposant sur la première couche du deuxième matériau diélectrique, puis la formation d'une couche diélectrique d'arrêt de gravure reposant sur et en contact avec la deuxième couche du première matériau ;
à l'étape a), la première couche du premier matériau est formée sur et en contact avec la couche d'arrêt de gravure ; et
à l'étape b), la gravure de la première couche du premier matériau est arrêtée sur la couche d'arrêt de gravure.

Selon un mode de réalisation :
à l'étape a), la première couche du premier matériau diélectrique repose sur un substrat semiconducteur dans lequel sont définies des zones de photoconversion de pixels d'un capteur de lumière, au moins un desdits pixels étant destiné à comprendre ledit au moins un filtre défini dans la première couche du premier matériau, et au moins un desdits pixels étant destiné à être dépourvu de filtre à résonance de Fano défini dans la première couche du premier matériau ; ou après l'étape d), un empilement comprenant les couches formées aux étapes précédentes est reporté au-dessus d'un substrat semiconducteur dans lequel sont définies des zones photosensibles de pixels d'un capteur de lumière, de sorte qu'au moins un desdits pixels comprenne ledit au moins un filtre défini dans la première couche du premier matériau, et au moins un desdits pixels soit dépourvu de filtre à résonance de Fano défini dans la première couche.

### Brève description des dessins

Ces caractéristiques et avantages, ainsi que d'autres, seront exposés en détail dans la description suivante de modes de réalisation et de modes de mise en oeuvre particuliers faite à titre non limitatif en relation avec les figures jointes parmi lesquelles :
la figure 1 est une vue schématique et en coupe d'une partie d'un capteur de lumière selon un mode de réalisation ;
la figure 2 est une vue schématique et en coupe d'une partie d'un capteur de lumière selon une variante de réalisation ;
la figure 3 est une vue schématique et en coupe d'une partie d'un capteur de lumière selon une autre variante de réalisation ;
la figure 4 est une vue schématique et en coupe d'une partie d'un capteur de lumière selon encore une autre variante de réalisation ;
la figure 5 est une vue schématique et en coupe d'une partie d'un capteur de lumière selon encore une autre variante de réalisation ; et
la figure 6 est une vue schématique et en coupe d'une partie d'un capteur de lumière selon encore une autre variante de réalisation ;
la figure 7 illustre par des vues de dessus et en coupe un mode de réalisation d'un filtre à résonance de Fano d'un capteur de lumière ;
la figure 8 illustre par des vues de dessus et en coupe une variante de réalisation du filtre de la figure 7 ;
la figure 9 illustre par des vues de dessus et en coupe un autre mode de réalisation d'un filtre à résonance de Fano d'un capteur de lumière ;
la figure 10 illustre par des vues de dessus et en coupe une variante de réalisation du filtre de la figure 9 ;
la figure 11 est une vue en coupe d'une structure à une étape d'un procédé de fabrication selon un mode de réalisation ;
la figure 12 est une vue en coupe de la structure de la figure 11 à une étape suivante du procédé ;
la figure 13 est une vue en coupe de la structure de la figure 12 à une étape suivante du procédé ;
la figure 14 est une vue en coupe de la structure de la figure 13 à une étape suivante du procédé ;
la figure 15 est une vue en coupe de la structure de la figure 14 à une étape suivante du procédé ;
la figure 16 est une vue en coupe de la structure de la figure 12 à une étape suivante du procédé selon une variante de réalisation ;
la figure 17 est une vue en coupe de la structure de la figure 11 à une étape suivante du procédé selon une variante de réalisation ; et
la figure 18 est une vue en coupe de la structure de la figure 17 à une étape suivante du procédé.

### Description des modes de réalisation

De mêmes éléments ont été désignés par de mêmes références dans les différentes figures. En particulier, les éléments structurels et/ou fonctionnels communs aux différents modes de réalisation et modes de mise en oeuvre peuvent présenter les mêmes références et peuvent disposer de propriétés structurelles, dimensionnelles et matérielles identiques.

Par souci de clarté, seuls les étapes et éléments utiles à la compréhension des modes de réalisation et des modes de mise en oeuvre décrits ont été représentés et sont détaillés. En particulier, les divers systèmes électroniques et applications dans lesquels un capteur de lumière peut être prévu n'ont pas été détaillés, les modes de réalisation décrits étant compatibles avec ces systèmes électroniques et applications usuels. En outre, les circuits de lecture d'un pixel d'un capteur, configurés pour générer un signal de sortie du pixel ayant une valeur représentative de la quantité de lumière reçue par une zone de photoconversion du pixel, n'ont pas été détaillés, les modes de réalisation décrits étant compatibles avec les circuits de lecture usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Dans la suite de la description, on appelle longueurs d'onde de fonctionnement d'un capteur de lumière, les longueurs d'onde comprises dans une plage de longueurs d'onde où le capteur est par exemple en mesure de fournir une analyse spectrale de la lumière reçue. Dans la suite de la description, on considère, à titre d'exemple, le cas d'un capteur dont les longueurs d'onde de fonctionnement sont comprises entre 300 nm et 900 nm.

Dans la suite de la description, un matériau est dit absorbant à une longueur d'onde par exemple si, lorsqu'un rayon lumineux à cette longueur d'onde frappe sous incidence normale une couche d'un micromètre d'épaisseur de ce matériau, au moins 90% de la puissance optique du rayon est absorbée par la couche et moins de 10 % de la puissance optique du rayon est réfléchie par la couche et/ou transmise à travers la couche.

Dans la suite de la description, lorsque l'on fait référence à une première couche reposant sur une deuxième couche, cela signifie, sauf précision contraire, que la première couche repose directement sur la deuxième couche, la première couche étant alors en contact avec la deuxième couche, ou indirectement sur la deuxième couche, une ou plusieurs couches étant alors intercalées entre les première et deuxième couches.

Dans la suite de la description, on appelle filtre à résonance de Fano un filtre utilisant le phénomène optique de résonance de Fano. Dans un tel filtre, la lumière incidente sur une structure périodique diélectrique du filtre excite un mode confiné de surface supporté par la surface de la structure périodique. Ce mode confiné ou localisé interfère avec la lumière réfléchie par la surface de la structure périodique. Lorsque le mode localisé et la lumière réfléchie ont la même phase, des interférences constructives entre le mode localisé et la lumière réfléchie conduisent à un pic de lumière réfléchie, ou, dit autrement, à un pic de réflexion de la lumière. Ainsi, il existe une longueur d'onde pour laquelle la lumière incidente sur le filtre est réfléchie à plus de 80 %, voire à plus de 90%, cette longueur d'onde déterminant la fréquence centrale du filtre. Un filtre à résonance de Fano se comporte donc comme un filtre coupe bande, contrairement, par exemple, à un filtre plasmonique.

Des exemples de filtres à résonance de Fano sont décrits dans l'article "Double-layer Fano resonance photonic crystal filters" de Yichen Shuai et al., publié dans Optics Express Vol. 21, Issue 21, pp. 24582-24589 (2013), et dans l'article "Structural Colors from Fano Resonances" de Yichen Shen et al., publié dans ACS Photonics 2015, 2, 1, 27-32.

Les inventeurs proposent ici un capteur de lumière tirant profit de la sélectivité des filtres à résonance de Fano (en anglais "Fano-resonance filters"). Plus particulièrement, les inventeurs proposent ici un capteur de lumière comprenant des pixels munis chacun d'une zone de photoconversion, dans lequel au moins un pixel est muni d'un filtre à résonance de Fano coupe bande ayant une fréquence centrale donnée, et au moins un autre pixel est dépourvu de filtre à résonance de Fano. Ainsi, lorsque le capteur reçoit de la lumière à analyser, en comparant la quantité de lumière reçue par la zone de photoconversion d'un pixel muni d'un filtre à résonance de Fano à celle reçue par la zone de photoconversion d'un pixel dépourvu d'un tel filtre, une information représentative de la proportion de lumière à analyser comprise dans une plage de longueurs d'onde sensiblement égale, voire égale, à la bande de réjection du filtre, peut être déterminée.

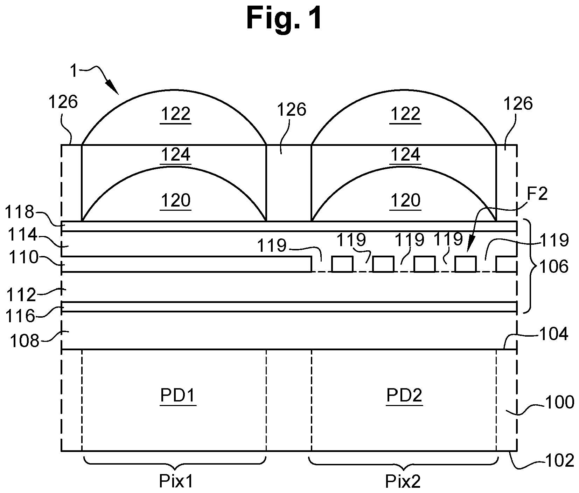

La figure 1 est une vue schématique et en coupe illustrant un mode de réalisation d'un tel capteur de lumière 1, une partie seulement du capteur 1 étant représentée en figure 1.

Le capteur 1 comprend des pixels, par exemple plusieurs dizaines de pixels, voire plusieurs centaines de pixels, bien que la partie du capteur 1 illustrée en figure 1 ne comprenne que deux pixels Pix1 et Pix2.

Le capteur 1 comprend un substrat semiconducteur 100, par exemple en silicium. Des composants et des circuits électroniques (non représentés en figure 1), par exemple des circuits de lecture des pixels du capteur 1, sont formés dans et/ou sur le substrat 100, du côté d'une face avant 102 du substrat 100 (face inférieure du substrat 100 en figure 1). Le substrat 100 comprend en outre une face arrière 104 (face supérieure du substrat 100 en figure 1), opposée et sensiblement parallèle, voire parallèle, à la face avant 102, la face arrière étant, dans cet exemple, destinée à recevoir de la lumière.

Chaque pixel du capteur 1 comprend une zone de photoconversion. Chaque zone de photoconversion s'étend dans le substrat 100, entre la face avant 102 du substrat 100 et la face arrière 104 du substrat 100, par exemple depuis la face avant 102 jusqu'à la face arrière 104. Les zones de photoconversion des pixels du capteur 1 sont isolées électriquement les unes des autres par des murs électriquement isolants non représentés en figure 1, ces murs isolants étant de préférence opaques aux longueurs d'onde de fonctionnement du capteur. Ces murs isolants délimitent latéralement les zones de photoconversion des pixels. En figure 1, seules des zones de photoconversion PD1 et PD2 des pixels respectifs Pix1 et Pix2 sont visibles et sont délimitées latéralement par des traits en pointillé.

Une structure 106 de filtrage de la lumière repose, par exemple indirectement, sur le substrat 100, sur la face 104 du substrat 100 destinée à recevoir de la lumière. Dans l'exemple de la figure 1, la structure 106 repose sur et en contact avec une couche 108 ou un empilement de couches isolantes 108, la ou les couches 108 reposant sur et en contact avec la face 104 du substrat 100. Dans un autre exemple non illustré, la ou les couches 108 sont omises, et la structure 106 repose sur et en contact avec la face 104 du substrat 100. De préférence, la structure 106 s'étend au-dessus de tous les pixels du capteur 1, chaque pixel comprenant alors une portion correspondante de cette structure 106.

La structure 106 comprend une couche 110 en un matériau diélectrique, ou dit autrement, un matériau isolant électriquement. Le matériau de la couche 110 est par exemple choisi parmi le carbone amorphe, le silicium amorphe, le nitrure de silicium, le silicium polycristallin non dopé, c'est-à-dire non intentionnellement dopé, et le carbure de silicium. La structure 106 comprend en outre une couche 112 et une couche 114, délimitées l'une par rapport à l'autre par des traits en pointillé en figure 1. Les couches 112 et 114 sont en un même matériau diélectrique, différent de celui de la couche 110. Le matériau des couches 112 et 114 est par exemple de l'oxyde de silicium ou du nitrure de silicium, de préférence de l'oxyde de silicium. La couche 110 repose sur la couche 112, et la couche 114 recouvre la couche 110, la couche 114 reposant sur et en contact avec la couche 110.

Dans le mode de réalisation de la figure 1, la couche 110 repose directement sur la couche 112. A titre d'exemple, l'épaisseur de la couche 110 est alors comprise entre 10 et 500 nm, par exemple égale à 200 nm.

Dans le mode de réalisation de la figure 1, la structure 106 comprend une couche ou revêtement antireflet 116 optionnel sur lequel repose la couche 112, la couche 112 reposant alors de préférence directement sur le revêtement antireflet 116, ou, dit autrement, en contact avec le revêtement 116.

Dans le mode de réalisation de la figure 1, la structure 106 comprend une couche ou revêtement antireflet 118 optionnel reposant sur la couche 114, le revêtement antireflet 118 reposant par exemple directement sur la couche 114.

La structure 106 comprend un ou plusieurs filtres à résonance de Fano, notamment un filtre F2 faisant partie du pixel Pix2. Le filtre F2 est disposé au-dessus et en regard de la zone PD2 du pixel Pix2.

En outre, la structure 106 est dépourvue de filtre à résonance de Fano au-dessus et en regard de la zone PD1 du pixel Pix1. Dit autrement, le pixel Pix1 ne comprend pas de filtre à résonance de Fano contrairement, par exemple, au pixel Pix2.

Ainsi, le capteur 1 comprend au moins un pixel, par exemple le pixel Pix2, comportant un filtre à résonance de Fano, et au moins un pixel, par exemple le pixel Pix1, dépourvu de filtre à résonance de Fano. Dans la suite de la description, un pixel est dit dépourvu de filtre à résonance de Fano lorsque ce pixel est dépourvu de filtre à résonance de Fano défini dans la structure 106, et, de manière analogue, un pixel est dit muni d'un filtre à résonance de Fano lorsque ce pixel comprend un filtre à résonance de Fano défini dans la structure 106.

Chaque filtre de la structure 106 comprend toutes les couches de la structure 106 et une structure périodique définie dans la couche 106 à l'emplacement du filtre, c'est-à-dire en regard de la zone photosensible du pixel comprenant ce filtre. En particulier, le filtre F2 du pixel Pix2 comprend une structure périodique définie dans la couche 110, au-dessus et en regard de sa zone de photoconversion PD2.

Dans le mode de réalisation de la figure 1, la structure périodique du filtre F2 est définie par des ouvertures 119 à travers toute l'épaisseur de la couche 104, le nombre de ces ouvertures pouvant être différent de celui représenté en figure 1.

En outre, dans le mode de réalisation de la figure 1, le pixel Pix1 dépourvu de filtre à résonance de Fano comprend toutes les couches de la structure 106, et en particulier la couche 110. Toutefois, aucune structure périodique de filtre à résonance de Fano n'est définie dans la couche 110 au-dessus et en regard de la zone de photoconversion PD1 du pixel Pix1 comme cela est représenté en figure 1, ou bien, une structure périodique est définie dans la couche 110 au-dessus et en regard de la zone de photoconversion PD1 du pixel Pix1 mais avec des dimensions qui ne conduisent pas à une résonance de Fano.

De préférence, comme cela est illustré en figure 1, le capteur 1 comprend en outre, au moins pour chaque pixel muni d'un filtre à résonance de Fano, un dispositif optique configuré pour que la lumière atteignant le filtre à résonance de Fano du pixel soit sous incidence normale par rapport au filtre, c'est-à-dire sous incidence normale par rapport à la surface supérieure de la couche 114, ou, dit autrement, sous incidence normale par rapport à la structure 106. De préférence, le ou les pixels du capteur 1 dépourvus de filtre à résonance de Fano, comprennent également chacun un tel dispositif optique de sorte que la lumière atteigne la structure 106 sous incidence normale, c'est-à-dire sous incidence normale par rapport à la surface supérieure de la couche 114. Ces dispositifs optiques reposent sur la structure 106, de préférence directement sur la structure 106.

Dans le mode de réalisation de la figure 1, pour chaque pixel concerné, notamment les pixels Pix1 et Pix2, ce dispositif optique comprend :
- un doublet de lentilles convergentes 120 et 122 disposées l'une au-dessous de l'autre ;
- une couche 124 d'un matériau diélectrique recouvrant la lentille inférieure 120 du doublet de lentilles et sur lequel repose la lentille supérieure 122 du doublet de lentilles ; et
- un mur latéral 126 en un matériau absorbant aux longueurs d'onde de fonctionnement du capteur, par exemple un mur 126 en résine noire, entourant latéralement le doublet de lentilles 120, 122, au moins sur toute la hauteur de l'empilement de la lentille 120 et du matériau 124. A titre d'exemple, les murs 126 sont alignés avec les murs d'isolation électrique (non représentés) délimitant latéralement les zones de photoconversion des pixels. Les distances focales des lentilles 120 et 122 et leur positionnement l'une par rapport à l'autre sont choisies pour que de la lumière traversant les lentilles 120 et 122 atteigne la structure 106 sous incidence normale.

Dans une variante de réalisation non illustrée, les lentilles 120 et 122 sont remplacées par un doublet de lentilles convergentes externes au capteur 1, par exemple deux lentilles externes disposées dans une ouverture d'un boîtier dans lequel est enfermé, ou encapsulé, le capteur 1. Dans cette variante, la couche 124 et/ou le mur 126 peuvent être omis.

Bien que cela ne soit pas représenté en figure 1, le capteur 1 comprend une structure d'interconnexion du côté de la face avant 102 du substrat 100, pour connecter électriquement les composants électroniques qui y sont formés.

Dans une variante de réalisation non illustrée, le capteur 1 est destiné à recevoir de la lumière du côté de la face avant 102 du substrat 100. Dans ce cas, la structure 106 repose alors sur la face 102 du substrat 100. Par exemple, la structure 106 repose sur la structure d'interconnexion reposant elle-même sur la face 102 sur substrat 100, et, lorsqu'ils sont prévus, les dispositifs optiques optionnels permettant, par exemple au moyen d'un doublet de lentilles convergentes, d'obtenir une lumière sous incidence normale par rapport à la structure 106 reposent alors sur la structure 106, du côté de la structure 106 opposé au substrat 100.

En outre, bien que cela ne soit pas représenté, le capteur 1 comprend un circuit de traitement configuré pour recevoir, au moins de chacun des pixels Pix1 et Pix2, de préférence de chaque pixel du capteur 1, un signal de sortie fourni par un circuit de lecture du pixel (non représenté). Ce signal de sortie est représentatif de la quantité de lumière reçue par la zone de photoconversion du pixel pendant une phase d'illumination ou d'intégration du capteur 1.

En fonctionnement, le capteur 1 reçoit de la lumière à analyser.

Les zones de photoconversion des pixels du capteur 1 munis d'un filtre à résonance de Fano reçoivent chacune de la lumière à analyser transportée par les longueurs d'onde de fonctionnement du capteur à l'exception des longueurs d'onde dans la bande de réjection du filtre à résonance de Fano de ce pixel. En outre, les zones de photoconversion des pixels du capteur 1 dépourvus de filtre à résonance de Fano reçoivent chacune de la lumière à analyser transportée par toutes les longueurs d'onde de fonctionnement du capteur 1. Pour chacun de ces pixels, munis ou non d'un filtre à résonance de Fano, le circuit de lecture du pixel fournit, par exemple au circuit de traitement du capteur 1, un signal de sortie représentatif de la quantité de lumière à analyser reçue par le pixel. Ainsi, le signal de sortie d'un pixel muni d'un filtre à résonance de Fano est représentatif de la proportion de lumière à analyser transportée par les longueurs d'onde de fonctionnement du capteur 1 à l'exception des longueurs d'onde dans la bande de réjection du filtre à résonance de Fano de ce pixel. De manière analogue, le signal de sortie d'un pixel dépourvu de filtre à résonance de Fano est représentatif de la proportion totale de lumière à analyser transportée par toutes les longueurs d'onde de fonctionnement du capteur 1.

Selon un mode de mise en oeuvre d'analyse de la lumière, le capteur 1, par exemple son circuit de traitement, est configuré pour fournir un signal ou une information représentative de la proportion de la lumière à analyser transportée par des longueurs d'onde dans la bande de réjection d'un filtre à résonance de Fano d'un premier pixel, à partir du signal de sortie du premier pixel et du signal de sortie d'un deuxième pixel dépourvu de filtre à résonance de Fano. Pour cela, le capteur 1, de préférence son circuit de traitement, est par exemple configuré pour soustraire la valeur du signal de sortie du premier pixel à celle du signal de sortie du deuxième pixel. Le résultat de cette soustraction est alors représentatif de la proportion ou quantité de lumière à analyser transportée par les longueurs d'onde dans la bande de réjection du filtre à résonance de Fano du premier pixel.

De préférence, le capteur 1, par exemple son circuit de traitement, est configuré pour appliquer un facteur correctif à la valeur du signal de sortie du premier pixel et/ou un facteur correctif à la valeur du signal de sortie du deuxième pixel, avant de les soustraire l'une à l'autre. Ce ou ces facteurs correctifs sont déterminés, par exemple lors d'une étape d'étalonnage du capteur 1, de manière à tenir compte, en dehors de la bande de réjection de filtre du premier pixel, des différences de transmission de la lumière à travers la portion de la structure 106 appartenant au premier pixel et à travers la portion de la structure 106 appartenant au deuxième pixel, et/ou de manière à tenir compte d'une éventuelle différence de surface entre les zones de photoconversion de ces premier et deuxième pixels. Ce ou ces facteurs correctifs peuvent par exemple être enregistrés dans une mémoire, de préférence non volatile, du capteur 1. En outre, la détermination de ces facteurs correctifs est à la portée de la personne du métier.

De préférence, le capteur 1, par exemple son circuit de traitement, est configuré pour normaliser les valeurs des signaux de sortie des premier et deuxième pixels par la valeur du signal de sortie du deuxième pixel dépourvu de filtre à résonance de Fano. Cette étape de normalisation peut être mise en oeuvre après avoir appliqué un facteur correctif à la valeur du signal de sortie du premier pixel et/ou un facteur correctif à la valeur du signal de sortie du deuxième pixel, ou être suivie de l'application d'un facteur correctif à la valeur normalisée de sortie du première pixel et/ou d'un facteur correctif à la valeur normalisée de sortie du deuxième pixel. Les facteurs correctifs sont par exemple déterminés de la façon décrite précédemment.

A titre d'exemple illustratif, en appelant λmin la longueur d'onde de fonctionnement minimale du capteur 1, λmax la longueur d'onde de fonctionnement maximale du capteur 1, λminF2 la longueur d'onde inférieure de la bande de réjection du filtre F2, par exemple de la bande de réjection à - 3dB du filtre F2, et λmaxF2 la longueur d'onde supérieure de la bande de réjection du filtre F2, par exemple de la bande de réjection à -3 dB du filtre F2, la zone de photoconversion du pixel Pix2 reçoit la lumière à analyser dont les longueurs d'onde sont comprises entre λmin et λminF2, et entre λmaxF2 et λmax, alors que la zone de photoconversion du pixel Pix1 reçoit la lumière à analyser dont les longueurs d'onde sont comprises entre λmin et λmax. Ainsi, le signal de sortie du pixel Pix2 est représentatif de la quantité de lumière à analyser reçue par la zone de photoconversion du pixel Pix2 pour des longueurs d'onde comprises entre λmin et λminF2, et entre λmaxF2 et λmax, le signal de sortie du pixel Pix1 étant représentatif de la lumière à analyser reçue par la zone de photoconversion du pixel Pix1 pour des longueurs d'onde comprises entre λmin et λmax. Le capteur 1, par exemple son circuit de traitement, fournit alors une information représentative de la proportion de la lumière à analyser reçue par le capteur qui est transportée par les longueurs d'onde comprises entre λminF2 et λmaxF2, par exemple en soustrayant la valeur du signal de sortie du pixel Pix2 à celle du pixel Pix1.

A titre d'exemple d'application, lorsque le capteur comprend plusieurs premiers pixels munis chacun d'un filtre à résonance de Fano défini dans la structure 106, et que les filtres à résonance de Fano ont des bandes de réjection différentes, le capteur 1 est par exemple utilisé pour obtenir une information représentative de la répartition spectrale de la lumière entre des plages de longueurs d'onde différentes correspondant chacune à une bande de réjection d'un filtre à résonance de Fano. Le capteur 1 constitue alors un capteur de lumière ambiante (« ambient light sensor »), ou ALS.

Selon un autre mode de mise en oeuvre d'analyse de lumière pouvant être utilisé indépendamment ou en combinaison du mode de mise en oeuvre décrit ci-dessus, une étape d'étalonnage du capteur 1 est prévue.

Lors de cette étape d'étalonnage, le capteur 1 est illuminé successivement avec différents types de lumière, c'est-à-dire avec des lumières ayant des spectres différents, par exemple de la lumière bleue, de la lumière naturelle, de la lumière émise par un écran, de la lumière incandescente, de la lumière fluorescente, de la lumière halogène, de la lumière provenant d'une source lumineuse définie et ayant traversé un échantillon connu, de la lumière provenant d'une source lumineuse définie et ayant été réfléchie par un échantillon connu, etc. Pour chaque type de lumière, le capteur 1, par exemple son circuit de traitement, est configuré pour mémoriser dans le capteur 1, par exemple dans une mémoire de préférence non volatile du capteur 1, l'ensemble des valeurs des signaux de sortie des pixels, de préférence après une étape de normalisation de ces valeurs par la valeur d'un signal de sortie d'un pixel dépourvu de filtre. Chaque ensemble de valeurs mémorisées constitue une cartographie des valeurs de sortie des pixels représentative du type de lumière reçue.

Lors d'une étape ultérieure où le capteur 1 reçoit de la lumière à analyser, l'ensemble des valeurs de sortie des pixels obtenues pour cette lumière à analyser, de préférence normalisées comme cela a été décrit précédemment, constituent une cartographie des valeurs de sortie des pixels représentative du type de lumière reçue. Cette cartographie est alors comparée par le capteur 1, par exemple par son circuit de traitement, aux cartographies mémorisées dans le capteur 1 lors de l'étape d'étalonnage de manière à déterminer le type de lumière à analyser reçue, voire, dans le cas où cette lumière est transmise à travers un échantillon à analyser ou réfléchie par un échantillon à analyser, la composition de l'échantillon. A titre d'exemple, le capteur 1, par exemple son circuit de traitement, est configuré pour calculer une information représentative de la différence entre la cartographie des valeurs de sortie des pixels obtenue pour la lumière à analyser et chacune des cartographies des valeurs de sortie des pixels mémorisées lors de la phase d'étalonnage, le type de lumière reçue étant alors identifié comme celui correspondant à la cartographie obtenue lors de la phase d'étalonnage pour laquelle cette différence est la plus faible, ou au moins considéré comme très proche du type de lumière correspondant à la cartographie obtenue lors de la phase d'étalonnage pour laquelle cette différence est la plus faible.

Un avantage du capteur 1 est qu'il peut comprendre plusieurs dizaines, voire plusieurs centaines de filtres à résonance de Fano ayant des fréquences centrales différentes, ce qui permet d'analyser la lumière sur plusieurs dizaines, voire plusieurs centaines de plages de longueurs d'onde.

Un autre avantage du capteur 1 est que chaque plage de longueurs d'onde d'analyse de la lumière correspondant à la bande de réjection d'un filtre à résonance de Fano est étroite et a, par exemple, une largeur ou étendue inférieure ou égale à 10 nm.

On aurait pu penser réaliser un capteur de lumière en utilisant des filtres interférométriques multicouches plutôt que des filtres à résonance de Fano. Toutefois, lorsque le capteur 1 est destiné à analyser la lumière sur plusieurs dizaines, voire plusieurs centaines de plages de longueurs d'onde, la fabrication d'un tel capteur est plus complexe, plus longue et plus coûteuse que celle du capteur 1.

On aurait également pu penser réaliser un capteur de lumière en utilisant des filtres plasmoniques plutôt que des filtres à résonance de Fano. Toutefois, les filtres plasmoniques ont une faible sélectivité spectrale et un tel capteur n'aurait pas permis d'analyser la lumière sur des plages étroites de longueurs d'onde, contrairement à ce que permet le capteur 1.

En outre, l'utilisation d'un capteur de lumière à filtres plasmoniques pour analyser la lumière sur au moins deux plages de longueurs d'onde relativement éloignées l'une de l'autre, par exemple deux plages de longueurs d'onde séparées l'une de l'autre par une plage de longueur d'onde d'une largeur de 400 nm, pose problème. En effet, du fait de l'éloignement entre ces deux plages d'analyse, le métal d'un filtre plasmonique permettant d'analyser la lumière dans l'une de ces deux plages diffère de celui d'un filtre plasmonique permettant d'analyser la lumière dans l'autre de ces deux plages. Cela rend le capteur à filtres plasmoniques et sa fabrication plus complexes et plus coûteux que pour le capteur 1.

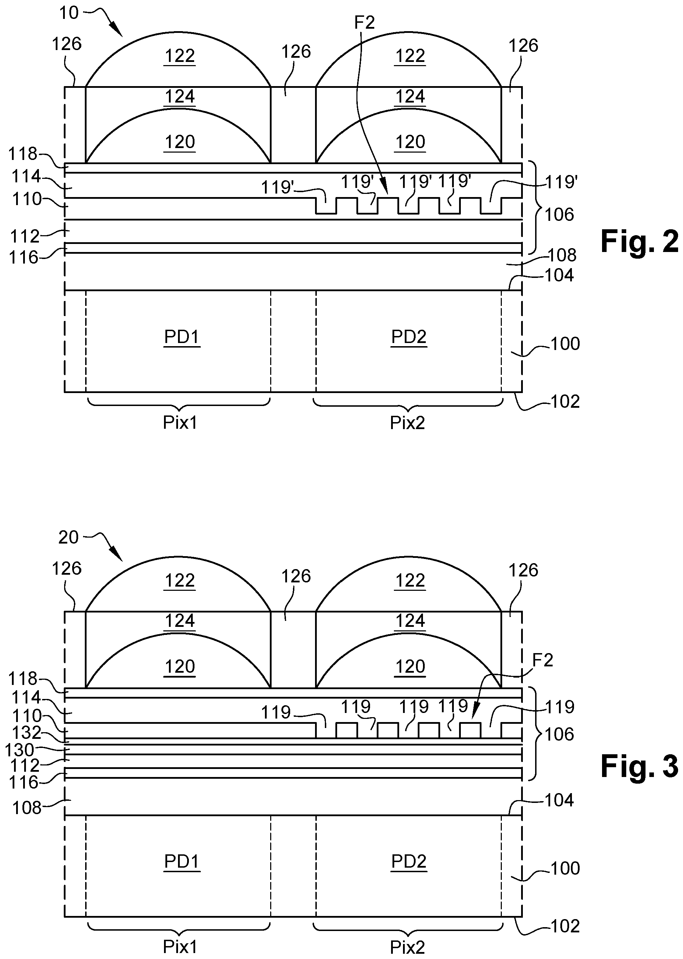

La figure 2 est une vue schématique et en coupe illustrant une variante de réalisation du capteur 1. Plus particulièrement, la figure 2 représente une partie seulement d'un capteur 10 selon cette variante de réalisation, la partie du capteur 10 représentée correspondant à la partie du capteur 1 représentée en figure 1. Seules les différences structurelles et éventuellement fonctionnelles entre les capteurs 1 et 10 sont ici détaillées.

Le capteur 10 de la figure 2 diffère du capteur 1 de la figure 1 uniquement par la façon dont sont réalisés les filtres à résonance de Fano. Plus particulièrement, comparé au capteur 1 de la figure 1 dans lequel la structure périodique d'un filtre à résonance de Fano est réalisée par des ouvertures 119 traversant la couche 110 sur toute son épaisseur, dans la variante de réalisation de la figure 2, la structure périodique d'un filtre à résonance de Fano est réalisée par des ouvertures ou cavités 119' ne traversant pas la couche 110 sur toute son épaisseur. Comme cela est par exemple représenté en figure 2 pour le filtre F2, les ouvertures 119' pénètrent dans la couche 110 à partir de la face de la couche 110 destinée à recevoir la lumière, ou, dit autrement, à partir de la face de la couche 110 opposée à la face de la couche 110 disposée du côté du substrat 100. A titre d'exemple, les ouvertures 119' pénètrent dans la couche 110 sur sensiblement la moitié de son épaisseur, par exemple sur la moitié de son épaisseur. A titre d'exemple, dans cette variante de réalisation, la couche 110 a la même épaisseur que dans le mode de réalisation de la figure 1.

La prévision d'ouvertures 119' ne traversant pas la couche 110 sur toute son épaisseur, par exemple ne pénétrant dans la couche que sur la moitié de son épaisseur, permet de réduire d'éventuelles résonnances parasites par rapport au cas de la figure 1.

La figure 3 est une vue schématique et en coupe illustrant une autre variante de réalisation du capteur 1. Plus particulièrement, la figure 3 représente une partie seulement d'un capteur 20 selon cette autre variante de réalisation, la partie du capteur 20 représentée correspondant à la partie du capteur 1 représentée en figure 1. Seules les différences structurelles et éventuellement fonctionnelles entre les capteurs 1 et 20 sont ici détaillées.

Le capteur 20 de la figure 3 diffère du capteur 1 de la figure 1 uniquement par la façon dont sont réalisés les filtres à résonance de Fano. Plus particulièrement, comparé au capteur 1 de la figure 1 dans lequel la couche 110 repose directement sur la couche 112, dans la variante de réalisation de la figure 3, la structure 106 comprend en outre une couche 130 en le même matériau que la couche 110, et une couche 132 en un matériau diélectrique tel que la couche 110 est gravable sélectivement par rapport à la couche 132. A titre d'exemple, la couche 132 est en le même matériau que les couches 112 et 114. A titre d'exemple, l'épaisseur de la couche 132 est comprise entre 2,5 nm et 15 nm, par exemple égale à 5 nm. A titre d'exemple, dans la variante de réalisation de la figure 3, l'épaisseur de la couche 110 est sensiblement égale, voire égale, à la moitié de l'épaisseur de la couche 110 du mode de réalisation de la figure 1. A titre d'exemple, l'épaisseur de la couche 130 est sensiblement égale, voire égale, à celle de la couche 110.

La couche 110 repose directement sur la couche 132, elle-même reposant directement sur la couche 130, la couche 130 reposant alors directement sur la couche 112. Les ouvertures 119 à travers toute l'épaisseur de la couche 110 débouchent alors sur la couche 132, ou, en variante, sur la couche 130 lorsque les portions de la couche 132 au fond des ouvertures 119 sont retirées.

La prévision de la couche 130 en le même matériau que la couche 110, par exemple avec une même épaisseur que la couche 110, permet de réduire d'éventuelles résonnances parasites par rapport au cas de la figure 1.

Les filtres à résonance de Fano mis en oeuvre selon les variantes de réalisation des figures 2 et 3 présentent moins de pics ou bandes de réjection secondaires en dehors de la bande de réjection principale du filtre, cette dernière étant sensiblement centrée sur la fréquence centrale du filtre. Dit autrement, les filtres à résonance de Fano selon les variantes de réalisation des figures 2 et 3 sont plus sélectifs que les filtres à résonance de Fano selon le mode de réalisation de la figure 1. En outre, les filtres à résonnance de Fano de la variante de réalisation de la figure 3 sont plus simples à réaliser que ceux de la variante de la figure 2, du fait que la couche 132 est utilisée comme couche d'arrêt de gravure des ouvertures 119.

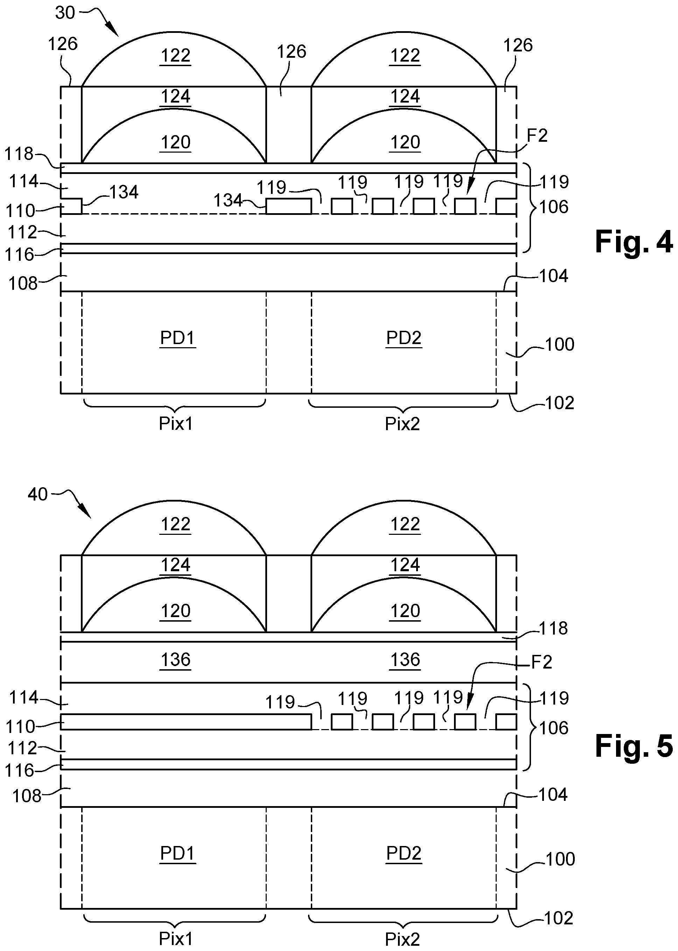

La figure 4 est une vue schématique et en coupe illustrant encore une autre variante de réalisation du capteur 1. Plus particulièrement, la figure 4 représente une partie seulement d'un capteur 30 selon cette autre variante de réalisation, la partie du capteur 30 représentée correspondant à la partie du capteur 1 représentée en figure 1. Seules les différences structurelles et éventuellement fonctionnelles entre les capteurs 1 et 30 sont ici détaillées.

Le capteur 30 de la figure 4 diffère du capteur 1 de la figure 1 uniquement par la façon dont est mise en oeuvre la structure 106 au-dessus de la zone de photoconversion d'un pixel dépourvu de filtre à résonance de Fano, comme c'est par exemple le cas du pixel Pix1. Plus particulièrement, comparé au capteur 1 de la figure 1 dans lequel la couche 110 de la structure 106 est présente au-dessus de la zone de photoconversion de chaque pixel, même lorsque le pixel est, comme le pixel Pix1, dépourvu de filtre à résonance de Fano, dans la variante de la figure 4, la couche 110 est interrompue au-dessus de la zone de photoconversion de chaque pixel dépourvu de filtre à résonance de Fano. Dit autrement, une portion de la couche 110 a été retirée au-dessus de la zone de photoconversion de chaque pixel dépourvu d'un filtre à résonance de Fano. Dit encore autrement, une ouverture 134 est prévue à travers toute l'épaisseur de la couche 110, au-dessus et en regard de la zone de photoconversion de chaque pixel dépourvu de filtre à résonance de Fano, les dimensions, en vue de dessus, de l'ouverture 134 étant au moins égales, voire supérieures, à celles de la zone de photoconversion du pixel.

La variante de réalisation de la figure 4 est compatible avec celles des figures 2 et 3. En particulier, dans le cas où la structure 106 comprend les couches 130 et 132 comme cela a été décrit en relation avec la figure 3, la couche 130 et/ou la couche 132 peuvent être interrompues de la même façon que la couche 110, au-dessus la zone de photoconversion de chaque pixel dépourvu de filtre à résonance de Fano.

La figure 5 est une vue schématique et en coupe illustrant encore une autre variante de réalisation du capteur 1. Plus particulièrement, la figure 5 représente une partie seulement d'un capteur 40 selon cette autre variante de réalisation, la partie du capteur 40 représentée correspondant à la partie du capteur 1 représentée en figure 1. Seules les différences structurelles et éventuellement fonctionnelles entre les capteurs 1 et 40 sont ici détaillées.

Dans cette variante, au moins certains pixels du capteur 40 comprennent, en plus de la structure 106 munie ou non d'un filtre à résonance de Fano selon le pixel considéré, un filtre supplémentaire 136 (ou structure de filtrage 136). Ce filtre supplémentaire est par exemple un filtre à résonance de Fano similaire au filtre F2 déjà décrit, un filtre multicouche interférométrique, un filtre plasmonique ou un filtre comprenant une résine colorée. Ce filtre 136 supplémentaire repose, de préférence directement, sur la structure 106, et plus particulièrement sur la couche 114 de la structure 106.

En fonctionnement, le capteur 40, par exemple son circuit de traitement, est alors de préférence configuré pour fournir une information représentative de la proportion de lumière à analyser transportée par des longueurs d'onde dans une bande de réjection d'un filtre à résonance de Fano à partir du signal de sortie du pixel comprenant ce filtre à résonance de Fano et du signal de sortie d'un pixel dépourvu de filtre à résonance de Fano dans la structure 106 mais muni d'un filtre 136 identique à celui du pixel comprenant le filtre à résonance de Fano.

A titre d'exemple, en figure 5, le pixel Pix1 et le pixel Pix2 comprennent chacun un filtre 136 en une même résine colorée. Ainsi, la zone de photoconversion PD1 du pixel Pix1 ne reçoit la lumière à analyser que dans une sous-plage de longueurs d'onde de fonctionnement du capteur 40, cette sous-plage étant définie par les propriétés de filtrage de la résine colorée, et la zone de photoconversion PD2 du pixel Pix2 ne reçoit la lumière à analyser que dans cette sous-plage de longueurs d'onde à l'exception des longueurs d'onde de la bande de réjection du filtre à résonance de Fano F2. Le capteur 40, de préférence son circuit de traitement, est par exemple configuré pour fournir une information représentative de la proportion de lumière à analyser transportée par les longueurs d'onde dans la bande de réjection du filtre F2 à partir des signaux de sortie des pixels Pix1 et Pix2 de la manière décrite en relation avec la figure 1. La prévision d'un filtre 136 permet d'améliorer le rapport signal sur bruit des signaux de sortie des pixels surmontés par ce filtre 136, du fait que la plage de longueur d'ondes de la lumière reçue par les zones de photoconversion de ces pixels est plus étroite qu'en l'absence du filtre 136.

Comme cela est représenté en figure 5, dans le cas où la structure 106 est revêtue de filtres 136, le revêtement antireflet optionnel 118, lorsqu'il est prévu, repose alors sur les filtres 136, et ne fait donc pas partie de la structure 106.

La variante de réalisation de la figure 5 est compatible avec les variantes de réalisation de la structure 106 telles que décrites en relation avec les figures 2, 3 et 4.

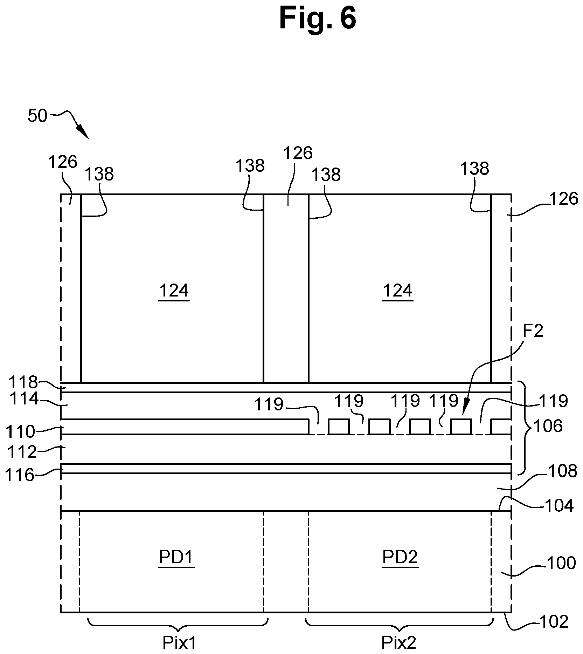

La figure 6 est une vue schématique et en coupe illustrant une autre variante de réalisation du capteur 1. Plus particulièrement, la figure 6 représente une partie seulement d'un capteur 50 selon cette autre variante de réalisation, la partie du capteur 50 représentée correspondant à la partie du capteur 1 représentée en figure 1. Seules les différences structurelles et éventuellement fonctionnelles entre les capteurs 1 et 50 sont ici détaillées.

Le capteur 50 de la figure 6 diffère du capteur 1 de la figure 1 uniquement par la façon dont sont mis en oeuvre les dispositifs optiques optionnels configurés pour que la lumière à analyser atteigne la structure 106 sous incidence normale. Plus particulièrement, en figure 6, dans chaque pixel concerné, notamment dans chacun des pixels Pix1 et Pix2, le dispositif optique est dépourvu des lentilles 120 et 122, et, en outre, le mur latéral 126 a une hauteur suffisante pour que la lumière à analyser passant dans une ouverture 138 délimitée latéralement par le mur 126, et disposée au-dessus et en vis-à-vis de la zone de photoconversion du pixel, atteigne la structure 106 sous incidence normale. La personne du métier est en mesure de déterminer la hauteur des murs 126 pour obtenir cette incidence normale.

Dans l'exemple représenté en figure 6, la couche 124 remplit chaque ouverture 138. La présence de la couche 124 confère une meilleure tenue mécanique au capteur 50 bien qu'elle puisse être omise.

Cette variante de réalisation est compatible avec les variantes de réalisation décrites en relation avec les figures 2, 3, 4 et 5.

Le fonctionnement des capteurs 10, 20, 30, 40 et 50 est similaire à celui du capteur 1 de la figure 1 et ne sera pas décrit à nouveau.

En outre, les capteurs 10, 20, 30, 40 et 50 bénéficient au moins des mêmes avantages que le capteur 1 de la figure 1.

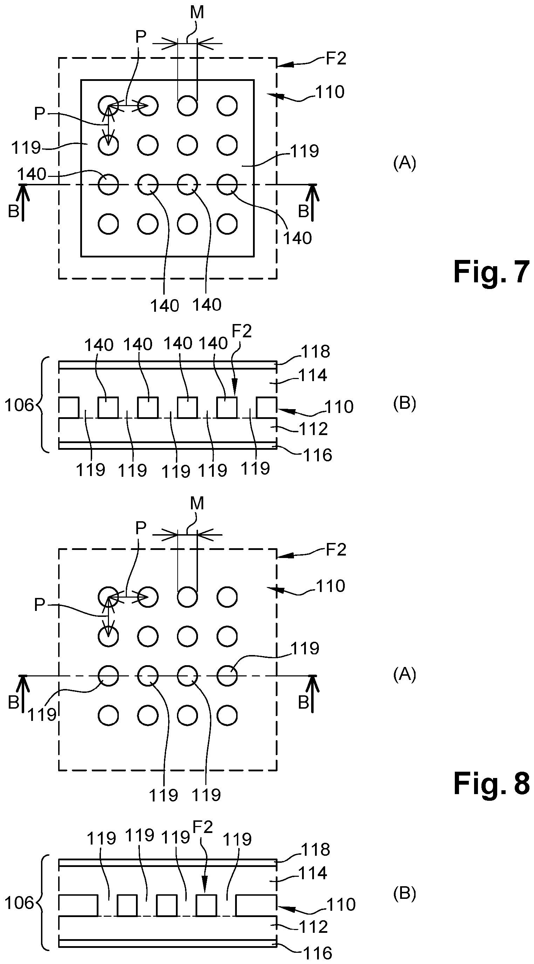

La figure 7 illustre par des vues de dessus (A) et en coupe (B) un mode de réalisation d'un filtre à résonance de Fano des capteurs 1, 30, 40 et 50, par exemple du filtre F2. La vue (B) de la figure 7 est une vue en coupe selon le plan BB de la vue (A) de la figure 7, et la couche 114 et le revêtement antireflet optionnel 118 ne sont pas représentés en vue (A) de la figure 7.

Dans ce mode de réalisation, la structure périodique du filtre F2 correspond à une répétition périodique d'un plot 140 du matériau de la couche 110, chaque plot 140 étant délimité latéralement par des ouvertures 119 correspondantes dans la couche 110. Plus exactement, le plot 140 est répété avec un pas P (vue (A)) dans deux directions orthogonales entre elles et parallèles au plan de la surface supérieure de la couche 110. Dans cet exemple, les plots 140 ont une forme circulaire en vue de dessus, ou, autrement dit, correspondent à des cylindres du matériau de la couche 110. Les plots 140 ont, dans un plan parallèle au plan de la surface supérieure de la couche 110, une dimension caractéristique M (vue (A)) correspondant, dans cet exemple, au diamètre des plots 140. Dans d'autres exemples non illustrés, ces plots 140 peuvent avoir, en vue de dessus, d'autres formes qu'une forme circulaire, par exemple la forme d'un carré de côté M.

Bien que l'on ait représenté en figure 7 un filtre F2 ne comprenant que 16 plots 140, en pratique le filtre F2 peut comprendre un nombre bien plus grand de plots 140, par exemple plusieurs dizaines, centaines voire milliers de plots 140.

La figure 8 illustre par des vues de dessus (A) et en coupe (B) une variante de réalisation du filtre F2 de la figure 7. La vue (B) de la figure 8 est une vue en coupe selon le plan BB de la vue (A) de la figure 8, et la couche 114 et le revêtement antireflet optionnel 118 ne sont pas représentés en vue (A) de la figure 8.

Dans cette variante de réalisation, la structure périodique du filtre F2 correspond à une répétition périodique d'une ouverture 119 dans la couche 110. Plus exactement, l'ouverture 119 est répétée avec un pas P (vue (A)) dans deux directions orthogonales entre elles et parallèles au plan de la surface supérieure de la couche 110. Dans cet exemple, les ouvertures 119 ont une forme circulaire en vue de dessus, ou, autrement dit, correspondent à des trous cylindriques à travers la couche 110. Les ouvertures 119 ont, dans un plan parallèle au plan de la surface supérieure de la couche 110, une dimension caractéristique M (vue (A)) correspondant, dans cet exemple, au diamètre des ouvertures 119. Dans d'autres exemples non illustrés, les ouvertures 119 périodiques peuvent avoir, en vue de dessus, d'autres formes qu'une forme circulaire, par exemple la forme d'un carré de côté M.

Bien que l'on ait représenté en figure 8 un filtre F2 ne comprenant que 16 ouvertures 119, en pratique le filtre F2 peut comprendre un nombre bien plus grand d'ouvertures 119, par exemple plusieurs dizaines, centaines voire milliers d'ouvertures 119.

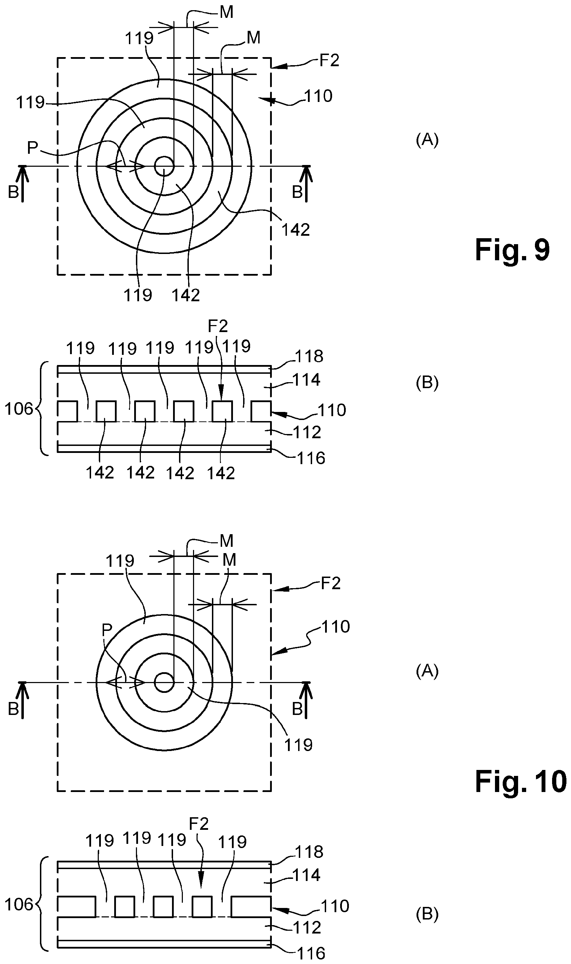

La figure 9 illustre par des vues de dessus (A) et en coupe (B) un autre mode de réalisation du filtre F2 du capteur 1. La vue (B) de la figure 9 est une vue en coupe selon le plan BB de la vue (A) de la figure 9, et la couche 114 et le revêtement antireflet optionnel 118 ne sont pas représentés en vue (A) de la figure 9.

Dans ce mode de réalisation, la structure périodique du filtre F2 correspond à des bandes 142 annulaires, de préférence circulaires, et concentriques en le matériau de la couche 110. Les bandes 142 sont réparties les unes par rapport aux autres avec un pas P (vue (A)), et séparées les unes des autres par des ouvertures 119, elles aussi annulaires et concentriques. Les bandes 142 ont, dans un plan parallèle au plan de la surface supérieure de la couche 110, une dimension caractéristique M (vue (A)) correspondant ici à leur largeur.

Bien que l'on ait représenté en figure 9 un filtre F2 ne comprenant que 2 bandes 142, en pratique le filtre F2 comprend un nombre bien plus grand de bandes 142, par exemple au moins dix bandes 142, de préférence plusieurs dizaines, centaines voire milliers de bandes 142.

La figure 10 illustre par des vues de dessus (A) et en coupe (B) une variante de réalisation du filtre F2 de la figure 9. La vue (B) de la figure 10 est une vue en coupe selon le plan BB de la vue (A) de la figure 10, et la couche 114 et le revêtement antireflet optionnel 118 ne sont pas représentés en vue (A) de la figure 10.

Dans cette variante de réalisation, la structure périodique du filtre F2 correspond à des ouvertures 119 annulaires, de préférence circulaires, et concentriques. Les ouvertures 119 sont réparties les unes par rapport aux autres avec un pas P (vue (A)), et séparées les unes des autres par des portions de la couche 110, elles aussi annulaires et concentriques. Les ouvertures 119 ont, dans un plan parallèle au plan de la surface supérieure de la couche 110, une dimension caractéristique M (vue (A)) correspondant ici à leur largeur.

Bien que l'on ait représenté en figure 10 un filtre F2 ne comprenant que deux ouvertures 119, en pratique le filtre F2 comprend un nombre bien plus grand d'ouvertures 119, par exemple au moins dix ouvertures 119, de préférence plusieurs dizaines, centaines voire milliers d'ouvertures 119.

Les filtres décrits en relation avec les figures 7, 8, 9 et 10 dans le cas où les ouvertures 119 traversent la couche 110 peuvent être adaptés à la variante de réalisation où la structure 106 comprend les couches supplémentaires 130 et 132 (figure 3), ou à la variante de réalisation où les ouvertures 119 sont remplacées par des ouvertures 119' (figure 2) qui ont, en vue de dessus, la même forme que les ouvertures 119 qu'elles remplacent mais qui ne traversent pas la couche 110.

Dans les divers modes de réalisation et variantes du filtre à résonance de Fano décrits ci-dessus en relation avec les figures 7, 8, 9 et 10, la fréquence centrale du filtre est au moins en partie déterminée par le pas P de la structure périodique, et aussi par la dimension M. La personne du métier est mesure de déterminer, pour des matériaux diélectriques donnés, le pas P et la dimension M permettant d'obtenir un filtre à résonance de Fano ayant une fréquence centrale désirée. Pour cela, la personne du métier peut utiliser un logiciel de simulation assistée par ordinateur tel que le logiciel désigné par l'appellation commerciale Lumerical. De préférence, pour un filtre à résonance de Fano ayant une fréquence centrale donnée, le pas P est inférieur à la longueur d'onde correspondant à cette fréquence centrale.

A titre d'exemple, en reprenant le filtre F2 de la figure 8, avec des couches 112 et 114 en oxyde de silicium, une couche 110 en nitrure de silicium, et une épaisseur de 100 nm pour la couche 110, les inventeurs ont obtenu des filtres F2 ayant :
- une fréquence centrale entre 350 et 355 nm quand P et M sont égaux respectivement à 210 nm et 140 nm ;
- une fréquence centrale entre 395 et 400 nm quand P et M sont égaux respectivement à 240 nm et 160 nm ;
- une fréquence centrale entre 435 et 440 nm quand P et M sont égaux respectivement à 270 nm et 180 nm ;
- une fréquence centrale entre 480 et 485 nm quand P et M sont égaux respectivement à 300 nm et 200 nm ;
- une fréquence centrale entre 520 et 525 nm quand P et M sont égaux respectivement à 330 nm et 220 nm ;
- une fréquence centrale entre 565 et 570 nm quand P et M sont égaux respectivement à 360 nm et 240 nm ;
- une fréquence centrale entre 605 et 610 nm quand P et M sont égaux respectivement à 390 nm et 260 nm ; et
- une fréquence centrale entre 650 et 655 nm quand P et M sont égaux respectivement à 420 nm et 280 nm.

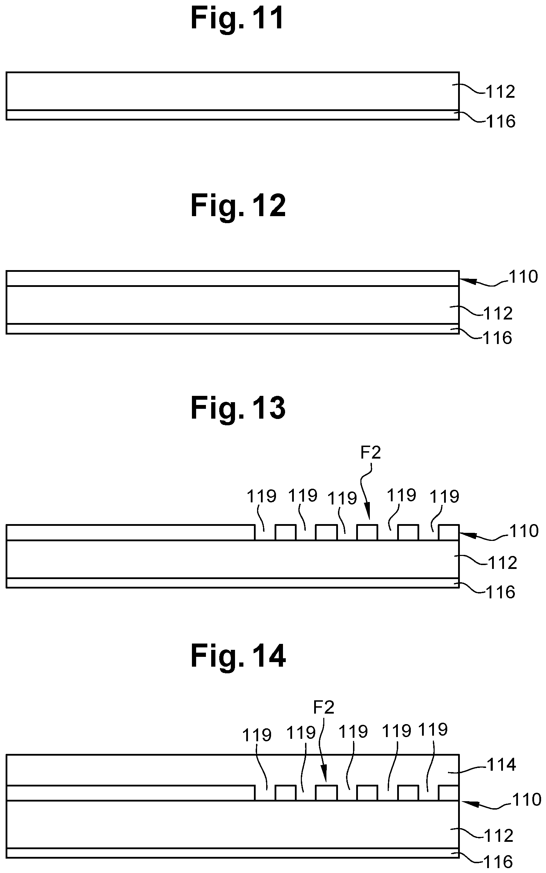

Les figures 11 à 15 sont des vues en coupe illustrant des étapes successives d'un mode de mise en oeuvre d'un procédé de fabrication d'une structure 106 telle que décrite en relation avec la figure 1, et plus particulièrement de la partie de la structure 106 représentée en figure 1 qui comprend le filtre F2.

En figure 11, la structure comprend la couche 112, et, dans le mode de mise en oeuvre illustré, le revêtement antireflet 116 optionnel recouvrant la face inférieure de la couche 112.

Selon un mode de mise en oeuvre, la couche 112 est formée, par exemple déposée, sur le substrat 100 (non représenté, voir par exemple la figure 1). Par exemple, le revêtement 116 est formé sur le substrat 100 ou, lorsqu'elle est présente, sur la couche 108, puis la couche 112 est formée, par exemple déposée, sur le revêtement 116. Dans le cas où le revêtement 116 n'est pas prévu, la couche 112 est formée, par exemple déposée, sur le substrat 100 ou sur la couche 108 lorsque celle-ci est présente.

Selon un autre mode de mise en oeuvre, la couche 112 est formée, par exemple déposée, sur un support temporaire (non illustré), par exemple un substrat de silicium. Par exemple, le revêtement 116 est formé sur le support temporaire puis la couche 112 est formée, par exemple déposée, sur le revêtement 116. Dans le cas où le revêtement 116 n'est pas prévu, la couche 112 est formée, par exemple déposée, sur le support temporaire.

En figure 12, la couche 110 est formée, par exemple déposée, sur la couche 112 de manière à recouvrir la couche 112. Plus particulièrement, la couche 110 est formée sur toute la face exposée de la couche 112, c'est-à-dire par exemple la face de la couche 112 opposée à la face de la couche 112 en contact avec, selon le cas, le revêtement 116, la couche 108, le substrat 100 ou le support temporaire.

Dans le mode de mise en oeuvre illustré par la figure 12, la couche 110 est formée directement sur la couche 112, et repose donc sur et en contact avec la couche 112.

En figure 13, la structure périodique du filtre F2 est définie dans la couche 110, en gravant des ouvertures 119 dans la couche 110 à l'emplacement du filtre F2.

A cette étape, simultanément à la gravure des ouvertures 119, une ou plusieurs ouvertures 134 (figure 4) peuvent être gravées à travers toute l'épaisseur de la couche 110, au niveau de chaque portion de la structure 106 destinée à être au-dessus de la zone de photoconversion d'un pixel dépourvu de filtre à résonance de Fano, comme c'est par exemple le cas du pixel Pix1 en figure 4 où une ouverture 134 est gravée au-dessus de la zone PD1. Ces ouvertures 134 ont des dimensions latérales telles qu'il ne s'y produit pas de résonnance de Fano, par exemple des dimensions latérales supérieures aux longueurs d'onde de fonctionnement du capteur.

En figure 14, la couche 114 est formée, par exemple déposée, sur la couche 110, de manière à recouvrir entièrement la couche 110 et à remplir les ouvertures 119. La face exposée de la couche 114, ici la face supérieure de la couche 114, est ensuite aplanie par polissage mécano-chimique ou CMP. Lors de l'étape de CMP une partie de l'épaisseur de la couche 114 peut être retirée de sorte que la couche 114 ait une épaisseur désirée.

Dans une variante de réalisation non illustrée, à l'étape de la figure 12, le dépôt de la couche 110 est remplacé par le dépôt d'une première couche en le matériau de la couche 112, puis, à l'étape de la figure 13, des plots complémentaires des ouvertures 119 sont définis par gravure dans la première couche. A l'étape de la figure 14, la couche 110 est déposée de manière à remplir les ouvertures dans la première couche, puis est retirée jusqu'au niveau de la face supérieure de la première couche, puis la couche 114 est déposée. Dans ce cas, les plots définis dans la première couche constituent les ouvertures dans la couche 110.

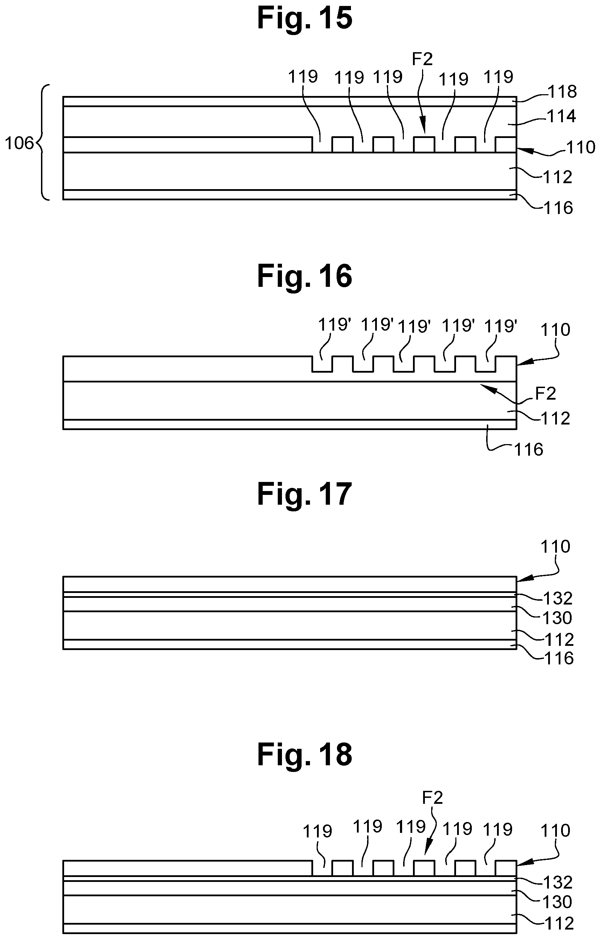

En figure 15, le revêtement antireflet 118 optionnel est formé, par exemple déposé, sur toute la face aplanie de la couche 114.

Dans le mode de mise en oeuvre illustré, le revêtement 118 est formé directement sur la couche 114 et l'on obtient la structure 106 telle que décrite en relation avec la figure 1.

Dans des variantes de mise en oeuvre non illustrées, une structure de filtrage 136 (figure 5) peut être formée directement sur la couche 114, préalablement à la formation optionnelle du revêtement 118. Dans ce cas, le revêtement optionnel 118, lorsqu'il est prévu, est alors formé à une étape ultérieure sur la structure de filtrage 136 et ne fait pas partie de la structure de filtrage 106.

Le dispositif optique configuré pour que, dans chaque pixel, la lumière atteigne la structure 106 sous incidence normale peut être formé lors d'étapes ultérieures à la portée de la personne du métier, par exemple en formant les lentilles 120, en déposant la couche 124, en aplanissant la couche 124, en gravant des tranchées à l'emplacement des murs 126, en déposant une couche du matériau des murs 126 pour remplir les tranchées et y former les murs, et en formant les lentilles 124.

Dans le mode de mise en oeuvre où la couche 112 est formée sur un support temporaire, on peut prévoir une étape de retrait du support temporaire, puis une étape de report, sur un substrat 100, de la structure 106 éventuellement surmontée de la structure de filtrage 136 et/ou des dispositifs optiques permettant d'obtenir de la lumière atteignant la structure 106 sous incidence normale. En variante, la structure 106 dépourvue de son support temporaire peut être disposée au-dessus du substrat 100, par exemple en étant maintenue dans une ouverture d'un boîtier dans lequel est encapsulé le substrat 100.

La figure 16 est une vue en coupe de la structure de la figure 12 à une étape suivante du procédé, selon une variante de réalisation dans laquelle le filtre F2 comprend des ouvertures 119' (figure 2) à la place des ouvertures 119.

Ainsi, en figure 16, au lieu de graver des ouvertures 119 sur toute l'épaisseur de la couche 110, les ouvertures ou cavités 119' sont gravées dans la couche 110, sur une partie seulement de l'épaisseur de la couche 110. La gravure est alors une gravure au temps, qui est arrêtée à la fin d'une durée prédéfinie permettant d'obtenir des ouvertures 119' de la profondeur voulue.

De manière similaire à ce qui a été décrit en relation avec la figure 13, on peut prévoir de graver, simultanément aux ouvertures 119', une ouverture similaire à l'ouverture 134 décrite en relation avec la figure 4, ayant la même profondeur que les ouvertures 119' et ne traversant donc pas la couche 110 sur toute son épaisseur.

Le procédé se poursuit ensuite par la mise en oeuvre des étapes décrites en relation avec les figures 14 et 15, l'éventuelle étape de formation d'une structure de filtrage supplémentaire 136, l'éventuelle étape de formation des dispositifs optiques permettant une incidence normale de la lumière sur la structure 106, et l'éventuelle étape de report.

La figure 17 est une vue en coupe de la structure de la figure 11 à une étape suivante du procédé, selon une variante de réalisation dans laquelle la structure 106 comprend les couches supplémentaires 130 et 132 (figure 3).

Ainsi, en figure 17, préalablement à la formation de la couche 110, les couches 130 et 132 ont été formées, par exemple déposées, sur la couche 112. La couche 110 a ensuite été formée, par exemple déposée, sur la couche 132. Plus particulièrement, la couche 130 est formée de manière à recouvrir entièrement la face supérieure de la couche 112, la couche 130 reposant alors sur et en contact avec la couche 112. La couche 132 est ensuite formée de manière à recouvrir entièrement la face supérieure de la couche 130, la couche 132 reposant alors sur et en contact avec la couche 130. Puis, la couche 110 est formée de manière à recouvrir entièrement la face supérieure de la couche 132, la couche 110 reposant alors sur et en contact avec la couche 132. Dit autrement, la couche 110 repose directement sur la couche 132, et indirectement sur la couche 112.

La figure 18 est une vue en coupe de la structure de la figure 17 à une étape suivante du procédé.

En figure 18, la structure périodique du filtre F2 est définie dans la couche 110, en gravant des ouvertures 119 dans la couche 110 à l'emplacement du filtre F2. Lors de la gravure des ouvertures 119, qui traversent la couche 110 sur toute son épaisseur, la couche 132 sert de couche d'arrêt de gravure. Une fois les ouvertures 119 gravées, les portions de la couche 132 exposées au fond des ouvertures 119 peuvent être laissées en place, ou alors retirées lors d'une étape de gravure suivante. La mise en oeuvre des masques permettant la gravure des ouvertures 119 et la gravure éventuelle des portions exposées de la couche 132 est à la portée de la personne du métier.

De manière similaire à ce qui a été décrit en relation avec la figure 13, simultanément à la gravure des ouvertures 119 et des éventuelles portions exposées de la couche 132, une ouverture 134 peut être gravée à travers la couche 110, et éventuellement à travers la couche 132, au niveau de chaque portion de la structure 106 destinée à être au-dessus de la zone de photoconversion d'un pixel dépourvu de filtre à résonance de Fano, comme c'est par exemple le cas du pixel Pix1 en figure 4.

Le procédé se poursuit ensuite par la mise en oeuvre des étapes décrites en relation avec les figures 14 et 15, l'éventuelle étape de formation d'une structure de filtrage supplémentaire 136, l'éventuelle étape de formation des dispositifs optiques permettant une incidence normale de la lumière sur la structure 106, et l'éventuelle étape de report.

On a décrit ci-dessus des modes de réalisation et variantes de réalisation d'une structure de filtrage 106 en ne décrivant qu'une partie de cette structure 106 dont une portion comprend un filtre F2 à résonance de Fano destiné au pixel Pix2, et dont une autre portion est dépourvue de filtre à résonance de Fano et est destinée au pixel Pix1. En pratique, la structure 106 peut comprendre un nombre non nul quelconque de portions dont chacune est destinée à un pixel correspondant et comprend un filtre à résonance de Fano du pixel, et un nombre non nul quelconque de portions dont chacune est destinée à un pixel correspondant et ne comprend aucun filtre à résonance de Fano. De telles portions, comprenant ou non un filtre à résonance de Fano, sont fabriquées simultanément par la mise en oeuvre des procédés décrits en relation avec les figures 11 à 18.

En outre, lorsqu'une structure 106 comprend plusieurs filtres à résonance de Fano, tous ces filtres ont de préférence une même structure périodique, le cas échéant avec des dimensions M et des pas P différents, donc des fréquences centrales différentes. Toutefois, il est également possible, sans étapes supplémentaires, de prévoir que des filtres de la structure 106 aient des structures périodiques différentes, par exemple qu'un filtre ait la structure décrite en relation avec la figure 8 et qu'un autre filtre ait la structure décrite en relation avec la figure 10.

Divers modes de réalisation et variantes ont été décrits. La personne du métier comprendra que certaines caractéristiques de ces divers modes de réalisation, modes de mise en oeuvre et variantes pourraient être combinées, et d'autres variantes apparaîtront à la personne du métier.

Enfin, la mise en oeuvre pratique des modes de réalisation, des modes de mise en oeuvre et des variantes décrits est à la portée de la personne du métier à partir des indications fonctionnelles données ci-dessus. En particulier, la personne du métier est en mesure de déterminer le nombre de filtres à résonance de Fano différents ainsi que le pas P et la dimension M de chacun de ces filtres, en fonction du nombre de plages de longueurs d'onde d'analyse de la lumière reçue par le capteur.

## Revendications

1. Capteur de lumière (1 ; 10 ; 20 ; 30 ; 40 ; 50) comprenant des pixels (Pix1, Pix2) comportant chacun une zone de photoconversion (PD1, PD2), dans lequel un premier (Pix2) desdits pixels comprend un premier filtre (F2) à résonance de Fano et un deuxième desdits pixels (Pix1) est dépourvu de filtre à résonance de Fano
**caractérisé en ce que** ledit premier filtre (F2) comprend une structure périodique définie dans une première couche (110) d'un premier matériau diélectrique, et
dans lequel ledit premier filtre (F2) comprend une première couche (112) d'un deuxième matériau diélectrique et une deuxième couche (114) du deuxième matériau diélectrique, la première couche (110) du premier matériau reposant sur la première couche (112) du deuxième matériau et étant recouverte par la deuxième couche (114) du deuxième matériau.

2. Capteur selon la revendication 1, dans lequel le premier matériau est choisi dans le groupe comprenant le carbone amorphe, le silicium amorphe, le nitrure de silicium, le silicium polycristallin non dopé et le carbure de silicium, le deuxième matériau étant de préférence de l'oxyde de silicium.

3. Capteur selon la revendication 1 ou 2, dans lequel :
la première couche (110) du premier matériau est en contact de la première couche (112) du deuxième matériau ; ou
le premier filtre (F2) comporte en outre une deuxième couche (130) du premier matériau reposant sur et en contact avec la première couche (112) du deuxième matériau, et une troisième couche (132) d'un matériau diélectrique, de préférence du deuxième matériau diélectrique, reposant sur et en contact avec la deuxième couche (130) du premier matériau, la première couche (110) du premier matériau reposant sur et contact avec ladite troisième couche (132).

4. Capteur selon l'une quelconque des revendications 1 à 3, dans lequel la première couche (112) du deuxième matériau repose sur un premier revêtement antireflet (116) et/ou un deuxième revêtement antireflet (118) repose sur la deuxième couche (114) du deuxième matériau.

5. Capteur selon l'une quelconque des revendications 1 à 4, dans lequel la structure périodique a un pas (P) inférieur à une longueur d'onde filtrée par ledit premier filtre (F2).

6. Capteur selon l'une quelconque des revendications 1 à 5, dans lequel un troisième desdits pixels comprend un deuxième filtre à résonance de Fano ayant une fréquence centrale différente de celle du premier filtre (F2).

7. Capteur selon la revendication 6, dans lequel le deuxième filtre comprend toutes les couches (110, 112, 114, 130, 132) du premier filtre et une structure périodique définie dans la première couche (110) du premier matériau.

8. Capteur selon l'une quelconque des revendications 1 à 7, dans lequel le premier filtre (F2) est de type coupe bande.

9. Capteur selon l'une quelconque des revendications 1 à 8, comprenant en outre un circuit configuré pour :
recevoir, de chacun desdits pixels (Pix1, Pix2), un signal de sortie représentatif de la quantité de lumière reçue par la zone de photoconversion (PD1, PD2) du pixel (Pix1, Pix2) pendant une phase d'illumination du capteur, et pour déterminer, à partir du signal de sortie du premier pixel (Pix2) et du signal de sortie du deuxième pixel (Pix1), une information représentative de la quantité de lumière reçue par le capteur (1) pendant la phase d'illumination dans une bande de réjection du premier filtre (F2).

10. Capteur selon l'une quelconque des revendications 1 à 9, dans lequel le premier pixel (Pix2) comporte en outre un dispositif configuré pour que de la lumière atteigne le premier filtre (F2) sous incidence normale.

11. Procédé de fabrication d'un capteur de lumière, selon la revendication 1, le procédé comprenant les étapes suivantes :
a) former la première couche (110) du premier matériau diélectrique reposant sur la première couche (112) du deuxième matériau diélectrique ;
b) former au moins le premier filtre à résonance de Fano (F2) en gravant, sur au moins une partie de l'épaisseur de la première couche (110) du premier matériau, des portions de la première couche du premier matériau pour y définir la structure périodique dudit au moins premier filtre (F2) ;
c) former la deuxième couche (114) du deuxième matériau de manière à recouvrir la première couche (110) du premier matériau ; et
d) aplanir une face exposée de la deuxième couche (114) du deuxième matériau par un polissage mécano-chimique.

12. Procédé selon la revendication 11, comprenant en outre :
avant l'étape a), une étape de formation d'un premier revêtement antireflet (116) sur lequel repose la première couche (112) du deuxième matériau ; et/ou
à l'étape d), une étape de formation d'un deuxième revêtement antireflet (118) reposant sur la deuxième couche (114) du deuxième matériau.

13. Procédé selon la revendication 11 ou 12, dans lequel :
l'étape a) comprend la formation d'une deuxième couche (130) du premier matériau diélectrique reposant sur la première couche (112) du deuxième matériau diélectrique, puis la formation d'une couche diélectrique (132) d'arrêt de gravure reposant sur et en contact avec la deuxième couche (130) du première matériau ;
à l'étape a), la première couche (110) du premier matériau est formée sur et en contact avec la couche d'arrêt de gravure (132) ; et
à l'étape b), la gravure de la première couche (110) du premier matériau est arrêtée sur la couche d'arrêt de gravure (132).

14. Procédé selon l'une quelconque des revendications 11 à 13, dans lequel :
à l'étape a), la première couche du premier matériau diélectrique repose sur un substrat semiconducteur dans lequel sont définies les zones de photoconversion des pixels (PD1, PD2) du capteur de lumière (1), au moins un desdits pixels étant destiné à comprendre ledit au moins premier filtre (F2) défini dans la première couche (110) du premier matériau, et au moins un desdits pixels étant destiné à être dépourvu de filtre à résonance de Fano défini dans la première couche (110) du premier matériau ; ou
après l'étape d), un empilement comprenant les couches formées aux étapes précédentes est reporté au-dessus d'un substrat semiconducteur dans lequel sont définies les zones photosensibles des pixels (PD1, PD2) du capteur de lumière (1), de sorte qu'au moins un desdits pixels comprenne ledit au moins premier filtre (F2) défini dans la première couche (110) du premier matériau, et au moins un desdits pixels soit dépourvu de filtre à résonance de Fano défini dans la première couche (110).

## Patentansprüche

1. Lichtsensor (1; 10; 20; 30; 40; 50) mit Pixeln (Pix1, Pix2), die jeweils einen Fotowandlungsbereich (PD1, PD2) aufweisen, wobei ein erstes (Pix2) der Pixel ein erstes Fano-Resonanzfilter (F2) und ein zweites der Pixel (Pix1) kein Fano-Resonanzfilter aufweist,
**dadurch gekennzeichnet, dass** das erste Filter (F2) eine periodische Struktur aufweist, die in einer ersten Schicht (110) eines ersten dielektrischen Materials definiert ist, und
wobei das erste Filter (F2) eine erste Schicht (112) eines zweiten dielektrischen Material und eine zweite Schicht (114) des zweiten dielektrischen Material aufweist, wobei die erste Schicht (110) des ersten Materials auf der ersten Schicht (112) des zweiten Materials aufliegt und von der zweiten Schicht (114) des zweiten Materials bedeckt ist.

2. Sensor nach Anspruch 1, wobei das erste Material aus der Gruppe ausgewählt ist, die amorphen Kohlenstoff, amorphes Silizium, Siliziumnitrid, undotiertes Polysilizium und Siliziumkarbid aufweist, wobei das zweite Material vorzugsweise Siliziumoxid ist.

3. Der Sensor nach Anspruch 1 oder 2, wobei:
die erste Schicht (110) des ersten Materials in Kontakt mit der ersten Schicht (112) des zweiten Materials ist;
oder das erste Filter (F1) ferner eine zweite Schicht (130) des ersten Materials aufweist, die auf der ersten Schicht (112) des zweiten Materials aufliegt und mit dieser in Kontakt steht, sowie eine dritte Schicht (132) aus dielektrischem Material, vorzugsweise aus dem zweiten dielektrischen Material, die auf der zweiten Schicht (130) des ersten Materials aufliegt und mit dieser in Kontakt steht, wobei die erste Schicht (110) des ersten Materials auf der dritten Schicht (132) aufliegt und mit dieser in Kontakt steht.

4. Sensor nach einem der Ansprüche 1 bis 3, wobei die erste Schicht (112) des zweiten Materials auf einer ersten Antireflexionsschicht (116) und/oder eine zweite Antireflexionsschicht (118) auf der zweiten Schicht (114) des zweiten Materials aufliegt.

5. Sensor nach einem der Ansprüche 1 bis 4, wobei die periodische Struktur eine Teilung (P) aufweist, die kleiner ist als eine durch das erste Filter (F2) gefilterte Wellenlänge.

6. Sensor nach einem der Ansprüche 1 bis 5, wobei ein drittes der Pixel ein zweites Fano-Resonanzfilter mit einer anderen Mittenfrequenz als die des ersten Filters (F2) aufweist.

7. Sensor nach Anspruch 6, wobei das zweite Filter alle Schichten (110, 112, 114, 130, 132) des ersten Filters und eine in der ersten Schicht (110) des ersten Materials definierte periodische Struktur umfasst.

8. Sensor nach einem der Ansprüche 1 bis 7, wobei das erste Filter (F2) vom Typ eines Bandsperrfilters ist.

9. Sensor nach einem der Ansprüche 1 bis 8, ferner aufweisend eine Schaltung, die konfiguriert ist:
zum Empfangen von jedem der Pixel (Pix1, Pix2) eines Ausgangssignals, das für die Lichtmenge repräsentativ ist, die von der Fotokonversionsfläche (PD1, PD2) des Pixels (Pix1, Pix2) während einer Pixelbeleuchtungsphase empfangen wird, und zum Bestimmen aus dem Ausgangssignal des ersten Pixels (Pix2) und aus dem Ausgangssignal des zweiten Pixels (Pix1) eine Information, die für die Lichtmenge repräsentativ ist, die von dem Sensor (1) während der Beleuchtungsphase in einem Sperrbereich des ersten Filters (F2) empfangen wird.

10. Sensor nach einem der Ansprüche 1 bis 9, wobei das erste Pixel (Pix2) ferner eine Vorrichtung aufweist, die so konfiguriert ist, dass das Licht das erste Filter (F2) unter normalem Einfall erreicht.

11. Herstellungsverfahren für einen Lichtsensor nach Anspruch 1, wobei das Verfahren die folgenden Schritte aufweist:
a) Ausbilden der ersten Schicht (110) des ersten dielektrischen Materials, die auf der ersten Schicht (112) des zweiten dielektrischen Materials aufliegt;
b) Ausbilden mindestens des ersten Fano-Resonanzfilters (F2) durch Ätzen von Teilen der ersten Schicht des ersten Materials über mindestens einen Teil der Dicke der ersten Schicht (110) des ersten Materials, um darin die periodische Struktur des mindestens ersten Filters (F2) zu definieren;
c) Ausbilden der zweiten Schicht (114) des zweiten Materials, um die erste Schicht (110) des ersten Materials zu bedecken; und
d) Planarisieren einer freiliegenden Oberfläche der zweiten Schicht (114) des zweiten Materials durch ein chemisch-mechanisches Polieren.

12. Verfahren nach Anspruch 11, ferner aufweisend:
vor Schritt a) einen Schritt des Ausbildens einer ersten Antireflexionsbeschichtung (116), auf der die erste Schicht (112) des zweiten Materials aufliegt; und/oder
in Schritt d) einen Schritt des Ausbildens einer zweiten Antireflexionsbeschichtung (118), die auf der zweiten Schicht (114) des zweiten Materials aufliegt.

13. Verfahren nach Anspruch 11 oder 12, wobei:
Schritt a) das Ausbilden einer zweiten Schicht (130) des ersten dielektrischen Materials aufweist, die auf der ersten Schicht (112) des zweiten dielektrischen Materials aufliegt, und dann das Ausbilden einer dielektrischen Ätzstoppschicht (132), die auf der zweiten Schicht (130) des ersten Materials aufliegt und mit dieser in Kontakt ist;
wobei in Schritt a) die erste Schicht (110) des ersten Materials auf der Ätzstoppschicht (132) und in Kontakt mit dieser ausgebildet wird; und
in Schritt b) das Ätzen der ersten Schicht (110) des ersten Materials auf der Ätzstoppschicht (132) gestoppt wird.

14. Verfahren nach einem der Ansprüche 11 bis 13, wobei:
im Schritt a) die erste Schicht des ersten dielektrischen Materials auf einem Halbleitersubstrat aufliegt, in dem die Fotokonversionsbereiche der Pixel (PD1, PD2) des Lichtsensors (1) definiert sind, wobei mindestens eines der Pixel dazu bestimmt ist, das mindestens erste Filter (F2) aufzuweisen, das in der ersten Schicht (110) des ersten Materials definiert ist, und mindestens eines der Pixel dazu bestimmt ist, kein Fano-Resonanzfilter aufzuweisen, das in der ersten Schicht (110) des ersten Materials definiert ist; oder
nach Schritt d) ein Stapel, der die in den vorhergehenden Schritten ausgebildeten Schichten aufweist, auf ein Halbleitersubstrat, in dem die lichtempfindlichen Bereiche der Pixel (PD1, PD2) des Lichtsensors (1) definiert sind, übertragen wird, so dass mindestens eines der Pixel das mindestens erste Filter (F2) aufweist, das in der ersten Schicht (110) des ersten Materials definiert ist, und wenigstens eines der Pixel kein in der ersten Schicht (110) definiertes Fano-Resonanzfilter aufweist.

## Claims

1. A light sensor (1; 10; 20; 30; 40; 50) comprising pixels (Pix1, Pix2), each comprising a photoconversion area (PD1, PD2), wherein a first one (Pix2) of said pixels comprises a first Fano resonance filter (F2) and a second one of said pixels (Pix1) comprises no Fano resonance filter
**characterized in that** said first filter (F2) comprises a periodic structure defined in a first layer (110) of a first dielectric material, and
wherein said first filter (F2) comprises a first layer (112) of a second dielectric material and a second layer (114) of the second dielectric material, the first layer (110) of the first material resting on the first layer (112) of the second material and being covered with the second layer (114) of the second material.

2. The sensor according to claim 1, wherein the first material is selected from the group comprising amorphous carbon, amorphous silicon, silicon nitride, non-doped polysilicon, and silicon carbide, the second material preferably being silicon oxide.

3. The sensor according to claim 1 or 2, wherein:
the first layer (110) of the first material is in contact with the first layer (112) of the second material; or
the first filter (F1) further comprises a second layer (130) of the first material resting on top of and in contact with the first layer (112) of the second material, and a third layer (132) of a dielectric material, preferably of the second dielectric material, resting on top of and in contact with the second layer (130) of the first material, the first layer (110) of the first material resting on top of and in contact with said third layer (132).

4. The sensor according to any of claims 1 to 3, wherein the first layer (112) of the second material rests on a first antireflection coating (116) and/or a second antireflection coating (118) rests on the second layer (114) of the second material.

5. The sensor according to any of claims 1 to 4, wherein the periodic structure has a pitch (P) smaller than a wavelength filtered by said first filter (F2).

6. The sensor according to any of claims 1 to 5, wherein a third one of said pixels comprises a second Fano resonance filter having a central frequency different from that of the first filter (F2).

7. The sensor according to claim 6, wherein the second filter comprises all the layers (110, 112, 114, 130, 132) of the first filter and a periodic structure defined in the first layer (110) of the first material.

8. The sensor according to any of claims 1 to 7, wherein the first filter (F2) is of band-stop filter type.

9. The sensor according to any of claims 1 to 8, further comprising a circuit configured to:
receive, from each of said pixels (Pix1, Pix2), an output signal representative of the quantity of light received by the photoconversion area (PD1, PD2) of the pixel (Pix1, Pix2) during a pixel illumination phase, and to determine, from the output signal of the first pixel (Pix2) and from the output signal of the second pixel (Pix1), an information representative of the quantity of light received by the sensor (1) during the illumination phase in a rejection band of the first filter (F2).

10. The sensor according to any of claims 1 to 9, wherein the first pixel (Pix2) further comprises a device configured so that light reaches the first filter (F2) under a normal incidence.

11. A manufacturing method of a light sensor, according to claim 1, the method comprising the following steps of:
a) forming the first layer (110) of the first dielectric material resting on the first layer (112) of the second dielectric material;
b) forming at least the first Fano resonance filter (F2) by etching, across at least part of the thickness of the first layer (110) of the first material, portions of the first layer of the first material to define therein the periodic structure of said at least first filter (F2);
c) forming the second layer (114) of the second material to cover the first layer (110) of the first material; and
d) planarizing an exposed surface of the second layer (114) of the second material by a chemical-mechanical polishing.

12. The method according to claim 11, further comprising:
before step a), a step of forming a first antireflection coating (116) having the first layer (112) of the second material resting thereon; and/or
at step d), a step of forming a second antireflection coating (118) resting on the second layer (114) of the second material.

13. The method according to claim 11 or 12, wherein:
step a) comprises the forming of a second layer (130) of the first dielectric material resting on the first layer (112) of the second dielectric material, and then the forming of a dielectric etch stop layer (132) resting on top of and in contact with the second layer (130) of the first material;
at step a), the first layer (110) of the first material is formed on top of and in contact with the etch stop layer (132); and
at step b), the etching of the first layer (110) of the first material is stopped on the etch stop layer (132).

14. The method according to any of claims 11 to 13, wherein:
at step a), the first layer of the first dielectric material rests on a semiconductor substrate having the photoconversion areas of the pixels (PD1, PD2) of the light sensor (1) defined therein, at least one of said pixels being intended to comprise said at least first filter (F2) defined in the first layer (110) of the first material, and at least one of said pixels being intended to comprise no Fano resonance filter defined in the first layer (110) of the first material; or
after step d), a stack comprising the layers formed at the previous steps is transferred above a semiconductor substrate having the photosensitive areas of the pixels (PD1, PD2) of the light sensor (1) defined therein, so that at least one of said pixels comprises said at least first filter (F2) defined in the first layer (110) of the first material, and at least one of said pixels comprises no Fano resonance filter defined in the first layer (110).
